(19) Europäisches Patentamt
European Patent Office
Office européen des brevets

(11) EP 0 572 135 B1

(12) EUROPEAN PATENT SPECIFICATION

(45) Date of publication and mention
of the grant of the patent:
01.09.1999 Bulletin 1999/35

(51) Int Cl.⁶: H03L 7/099, H03L 7/081

(21) Application number: 93303610.5

(22) Date of filing: 10.05.1993

(54) **State machine phase lock loop**

Phasenregelkreis mit einer Zustandsmaschine

Boucle à verrouillage de phase à machine d'états

(84) Designated Contracting States:
DE FR GB IT NL

(30) Priority: 26.05.1992 US 888907
28.01.1993 US 10107

(43) Date of publication of application:
01.12.1993 Bulletin 1993/48

(73) Proprietor: DIGITAL EQUIPMENT CORPORATION
Maynard, Massachusetts 01745 (US)

(72) Inventors:
• Lundberg, James R.
Austin, Texas 78703 (US)
• Wolrich, Gilbert M.
Framingham, Massachusetts 01701 (US)

(74) Representative: Goodman, Christopher et al
Eric Potter Clarkson,
Park View House,
58 The Ropewalk
Nottingham NG1 5DD (GB)

(56) References cited:
EP-A- 0 240 232          EP-A- 0 318 155
US-A- 3 789 308

• THE TRANSACTIONS OF THE INSTITUTE OF
ELECTRONICS, INFORMATION AND COMM.
ENGINEERS vol. E72, no. 3 , March 1989 ,
TOKYO,JP pages 194 - 201 S. MORI ET. AL.
'PERFORMANCE IMPROVEMENT OF ALL
DIGITAL PHASE LOCKED LOOP WITH
ADAPTIVE MULTILEVEL QUANTIZED PHASE
COMPARATOR'
• ELECTRONIC COMPONENTS AND
APPLICATIONS vol. 9, no. 2 , 1989 , EINDHOVEN
,NL pages 66 - 89 W. ROSINK 'ALL-DIGITAL
PHASE LOCKED LOOPS USING THE
74HC/HCT297'

**Description**

## BACKGROUND OF THE INVENTION

1. Field of the Invention

The present invention relates generally to digital electronics, and more specifically to a phase lock loop for synchronizing data processing units. In particular, the present invention relates to a phase lock loop using synchronous digital logic for phase modulation and phase detection.

2. Background of the Invention

Synchronous interfaces are desirable for removing latency required for synchronizing signals transmitted across an asynchronous boundary between data processing units. This latency translates directly into a performance penalty.

One method of achieving a synchronous interface in a data processing system is to distribute a global clock to the data processing units in the system. With present levels of circuit integration, however, a microprocessor or interface chip can have significant clock loading that can require several stages of buffering before a final clock buffer has sufficient drive capability. The worst-case skew attributable to the buffering stages can be prohibitive and limit the performance of the system design. Another drawback of a global clock is that all components are constrained to run at a given clock frequency. Data processor frequencies, however, are usually much higher than the interface frequencies. It is thus desirable to have a mechanism that can synchronize the clocks of the data processing units to a reference clock of a lower frequency.

A digital phase lock loop is capable of achieving the desired synchronization. But there are drawbacks associated with conventional digital phase lock loops. A conventional digital phase lock loop includes a voltage-controlled oscillator and an analog loop filter. These components can either be off-chip, adding potential secondary noise problems, or on-chip, where the area required for implementation could be prohibitively large. There is also jitter associated with digital phase lock loops that causes clock phase contraction and thus negatively impacts performance. In addition, some environments, particularly CMOS, are traditionally noisy, exacerbating jitter and resulting in risk to both acquisition and maintenance of phase lock.

Delay lock loops are also capable of achieving the desired synchronization by control of delay in a delay line. But delay lock loops also have attendant drawbacks and risks. If the delay line uses an analog control voltage, it is subject to the same problems mentioned above for conventional phase lock loops. If the delay line uses digital delays, then there is a penalty of clock phase contraction incurred when the delay lock loop must decrement.

It is therefore desirable to eliminate the risk, performance penalties, and cost associated with synchronization by conventional techniques.

EP-0318155, EP-0240232, US-3789308 and IEICE Transactions Vol E72, no. 3, March 1989, pages 194-201 all describe digital phase lock loop systems. In particular, US-3789308 describes a phase lock loop system which uses an input signal of frequency $f_S$ and a coherent signal of frequency $2^n \times f_S$ to produce an output square wave of frequency $f_S$. An n-stage counter is driven by the $2^n \times f_S$ source producing an output square wave of frequency $f_S$ which acts as a reference for a phase detector which, together with an A/D converter, generates a digital error signal which advances or retards the phase of the output signal proportional to the measured phase error.

## SUMMARY OF THE INVENTION

The invention in its broad form resides in a method for synchronizing a first signal to a second signal as recited in claim 1 and a digital phase lock loop as recited in claims 5 and 8.

As described hereinafter, a digital phase lock loop synchronizes a first signal to a second signal. The first signal has an instantaneous frequency that is usually greater than the frequency of the second signal, so that the first signal constantly gains phase with respect to the second signal. The digital phase lock loop selectively expands the phase of the first signal by a predefined amount when a predefined phase relationship is detected between the first signal and the second signal. The phase lock loop periodically follows a correction cycle, in which the phase of the first signal drifts with respect to the second signal until the predefined phase relationship is detected, and then the phase of first clock is selectively expanded.

In a specific implementation, the digital phase lock loop is comprised of synchronous logic clocked by a clocking signal, and therefore the digital phase lock loop is a "state machine." The first signal is generated by a frequency divider such as a counter clocked by the clocking signal, and phase expansion is performed by inhibiting the counter for one cycle of the clocking signal. A digital phase detector detects a predetermined phase error of one cycle of the clocking signal. The predetermined phase relationship is detected when the second signal has a predetermined logic state coincidence with clocking by the clocking signal and a predefined state of the frequency divider or counter. Noise immunity is achieved by requiring the predefined phase relationship to be detected over a plurality of cycles of the first and second signals before performing a phase expansion. Moreover, when a phase expansion is performed, the performance of a subsequent phase expansion is inhibited for a predetermined duration of time so as to limit the rate of phase expansion. Therefore, when the second signal is corrupted by noise, the average frequency of the first signal is constrained to be within predefined limits about the frequency of the second frequency.

## BRIEF DESCRIPTION OF THE DRAWINGS

A more detailed understanding of the invention may be had from the following description of a preferred embodiment, given by way of example and to be studied in conjunction with the accompanying drawing wherein:

FIG. 1 is a block diagram of a data processing system using state machine phase lock loops in accordance with an embodiment of the present invention for synchronizing data processing units in the system;

FIG. 2 is a flow diagram illustrating a phase correction cycle in the operation of specific embodiments of the present invention;

FIGs. 3A to 3D are timing diagrams illustrating the relative phase relationships between signals in the specific embodiments of the present invention for respective states in the flow diagram of FIG. 2;

FIG. 4 is a block diagram of a first embodiment of the state machine phase lock loop of the present invention;

FIG. 5 is a schematic diagram of a specific circuit for the state machine phase lock loop generally shown in FIG. 4;

FIG. 6 is a block diagram of a second embodiment of the state machine phase lock loop of the present invention; and

FIG. 7 is a schematic diagram of a specific circuit for the state machine phase lock loop generally shown in FIG. 6.

While the invention will be described in connection with certain preferred embodiments, it will be understood that it is not intended to limit the invention to these particular embodiments. On the contrary, it is intended to cover all modifications, alternatives, and equivalent arrangements as may be included within the scope of the invention.

## DESCRIPTION OF THE PREFERRED EMBODIMENTS

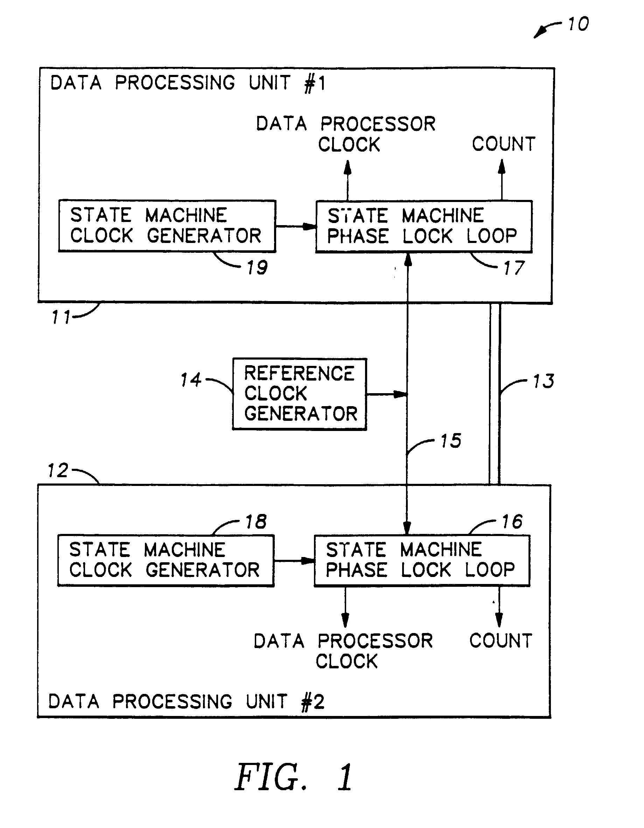

Referring now to FIG. 1, there is shown a data processing system generally designated 10 including a first data processing unit 11 and a second data processing unit 12 interconnected by a data bus 13. The data processing units, for example, reside on separate circuit boards and include separate microprocessor chips. Due to the very high level of integration presently available for manufacturing microprocessor chips, the clocking frequency of each microprocessor chip exceeds the clocking rate which is convenient for transmitting data across the data bus 13. Therefore, some means is required for synchronizing the reception of data transmitted by one of the data processing units to the other of the data processing units. A most efficient way of synchronizing the reception of the data is to synchronize the two processors. Such synchronization of the data processing units in a computer system is also desirable in multiprocessing systems where certain transactions are issued time stamps for enforcing serialization orders of execution of the transactions.

One method of synchronizing data processing units is to use a common reference clock. As shown in FIG. 1, a reference clock generator 14 generates such a common reference clock which is distributed over a clock line 15 to the data processing units 11, 12.

In a common arrangement where a number of data processing units share a common reference clock, the reference clock is provided as the data processor clock to each of the data processing units. Due to the ever increasing clocking speed of the data processing units, however, it is becoming increasingly impractical to distribute such a high speed clock among a number of data processing units without the introduction of substantial clocking skew and noise. Therefore, it is desirable to distribute a reference clock that is at a submultiple of the clocking frequencies of the data processing units, and to use some kind of means for synchronizing the data processor clocks with the reference clock.

As described herein, each of the data processing units includes a state machine phase lock loop for generating a data processor clock synchronized to the common reference clock. Each of the state machine phase lock loops 16, 17 is clocked by a respective state machine clock generator, and each state machine phase lock loop selectively expands the phase of the data processor clock. Each state machine also provides a count to each data processor identifying the phase of the reference clock relative to the data processor clock.

In a specific example, the state machine clock generators provide a frequency slightly greater than six times the frequency of the reference clock generator 14, and the data processor clocks are synchronized to a frequency of three times the frequency of the reference clock generator.

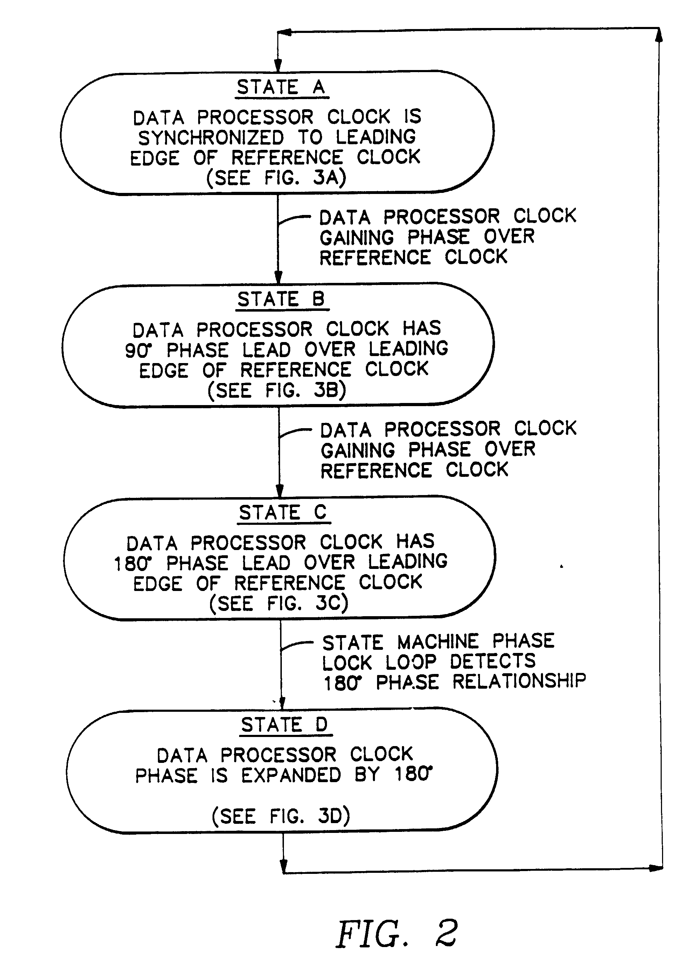

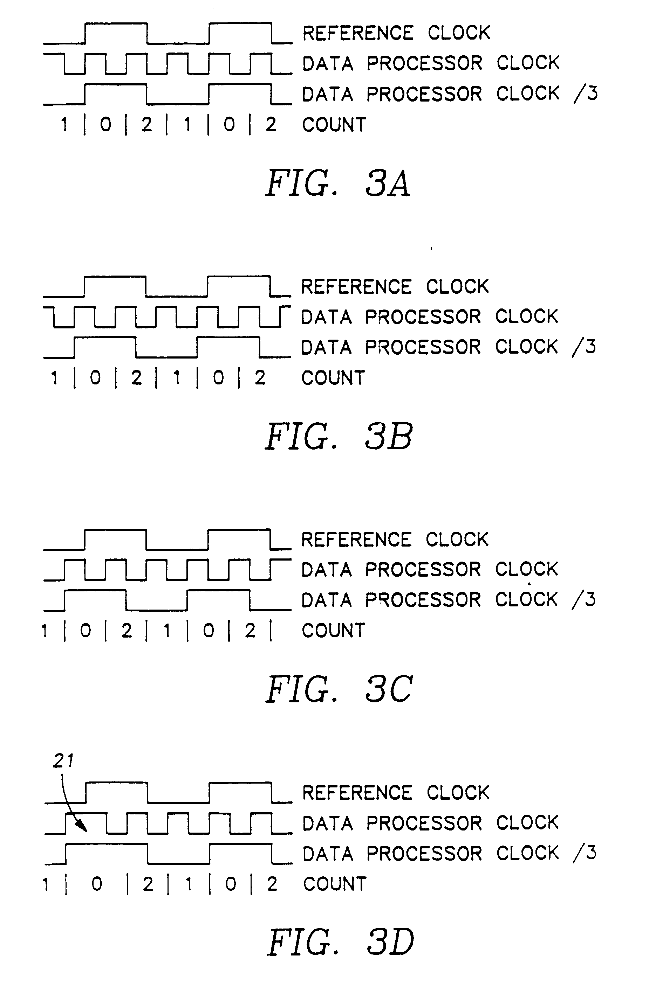

Advantageously, a state machine phase lock loop selectively expands the phase of its respective data processor clock by a predefined amount during a phase correction cycle as illustrated in the flow diagram of FIG. 2. Shown in FIG. 2 are various states labeled STATE A, STATE B, STATE C, and STATE D, corresponding to relationships between the respective clocks as illustrated in FIGs. 3A, 3B, 3C, and 3D, respectively. In STATE A, and as shown in FIG. 3A, the data processor clock is synchronized to the leading edge of the reference clock. From this initial relationship, the data processor clock slowly gains phase over the reference clock, eventually reaching an intermediate relationship in STATE B, where the data processor clock has a 90° phase lead over the leading edge of the reference clock. This relationship is shown in FIG. 3B. The data processor clock continues to gain phase over the reference clock until a STATE C is reached, wherein the data processor clock has a 180° phase lead over the leading edge of the reference clock. This 180° phase relationship is illustrated in FIG. 3C. When the state machine phase lock loop detects this 180° phase relationship, a STATE D is reached, wherein the phase of the data processor clock is expanded by 180°, as shown in FIG. 3D. The phase expansion is performed during a single cycle, generally designated 21, of the data processor clock. This phase expansion causes an immediate synchronization of the data processor clock to the leading edge of the reference clock to achieve STATE A of the correction cycle.

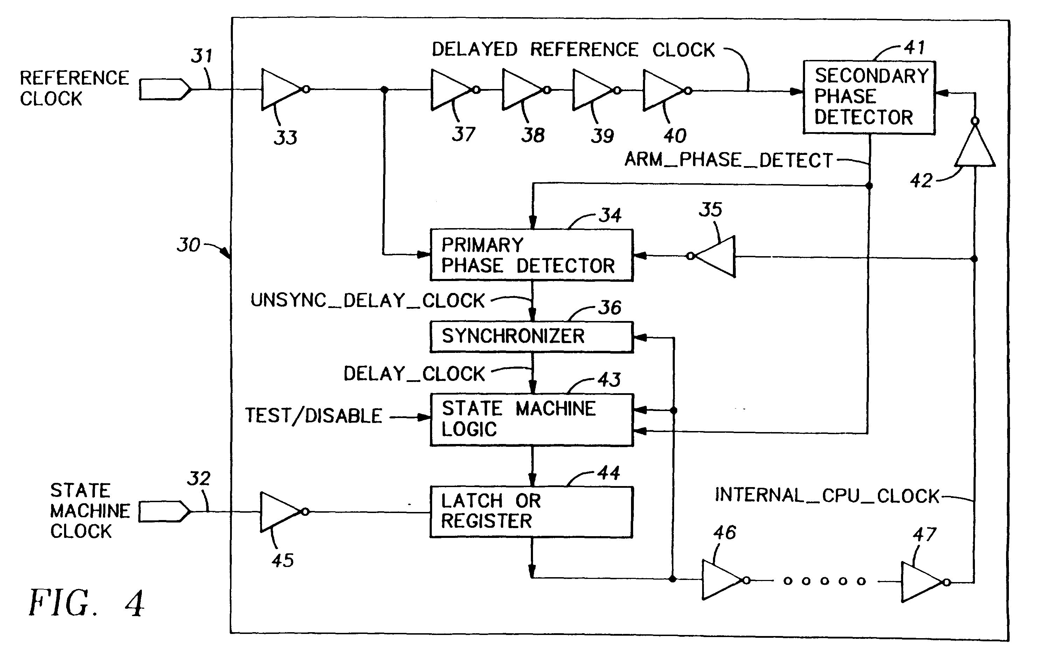

Turning now to FIG. 4, there is shown a block diagram of a first embodiment of a state machine phase lock loop incorporating the present invention. The state machine phase lock loop is fabricated on an integrated circuit chip 30, and provides an internal CPU clock signal to an on-chip data processor (not shown). The reference clock signal is supplied to a chip lead 31, and the state machine clock signal is supplied to a chip lead 32. The reference clock is fed through an inverter 33 to a primary phase detector 34, and the internal CPU clock is fed through an inverter 35 to the primary phase detector. The primary phase detector 34 detects when the internal data processor clock reaches the state shown in FIG. 3C. The output of the primary phase detector is a signal (UNSYNC-DELAY-CLOCK) that causes the state machine phase-lock loop to make a phase correction as shown in FIG. 3D. That signal (USYNC-DELAY-CLOCK) is fed through a synchronizer 36 so that the signal is synchronized to the state machine domain (which is an early version of the internal CPU clock) in order to prevent the propagation of a potential metastable signal into the state machine.

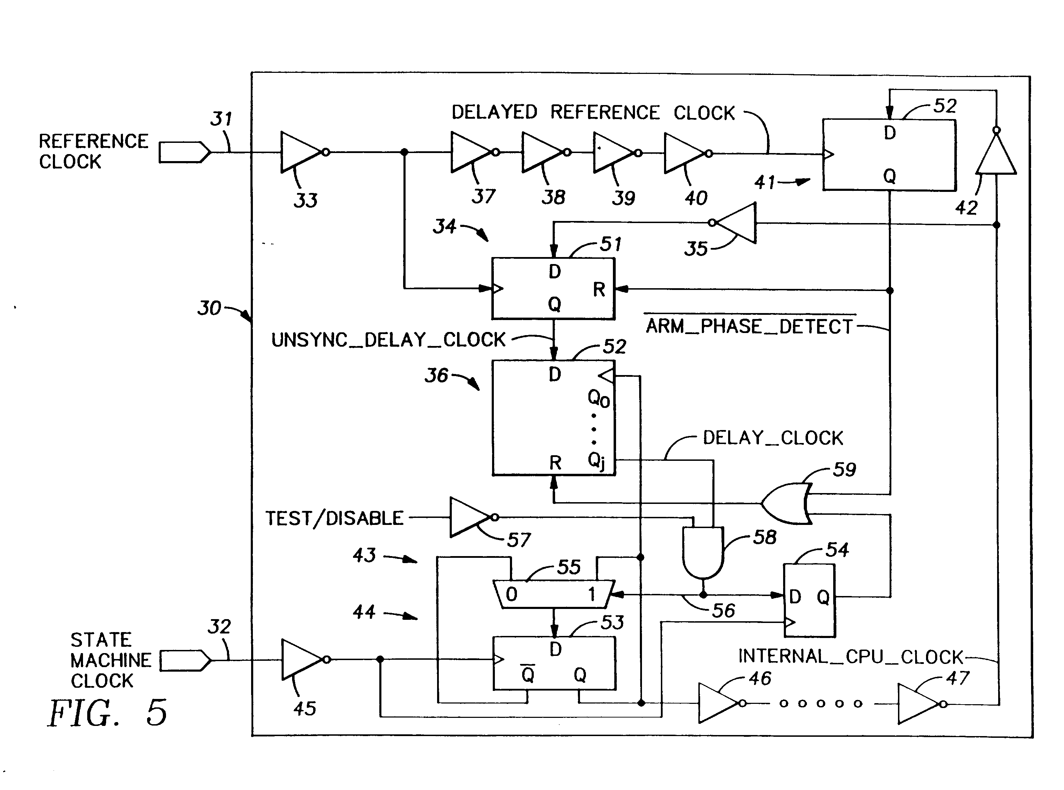

A delayed version of the reference clock is obtained by passing the reference clock from the inverter 33 through four additional inverters 37, 38, 39, and 40. The delayed reference clock is fed to a secondary phase detector 41, and the internal CPU clock is fed through an inverter 42 to the secondary phase detector. The secondary phase detector is used to enable the primary phase detector and can be used with other control logic, as shown below with reference to FIG. 5, to ensure that the state machine phase-lock loop does not make more than one phase expansion (21 in FIG. 3D) per correction cycle. The secondary phase detector 41 also ensures that there will not be a false detection due to inherent system jitter after a phase expansion. The secondary phase detector 41 output (ARM-PHASE-DETECT) and the synchronizer 36 output (DELAY_CLOCK) are fed to state machine logic 43. It is not necessary to synchronize the output of the secondary phase detector since a metastable state after a correction will have no effect on the primary phase detector or the state machine. By the time that a metastable state could affect the primary phase detector 34, the output of the secondary phase detector is guaranteed stable. Moreover, there is very little penalty in synchronizing the control signals since the internal CPU clock is drifting very, very slowly with respect to the reference clock. Thus, when the primary phase detector 34 has been triggered, the skew (a few picoseconds) introduced by the delay of the synchronizer 36 has a negligible impact on system jitter.

The state machine of FIG. 4 is the combination of the state machine logic 43 and a latch or register 44 that provides a feedback path to and from the state machine logic. The state machine clock on lead 32 is buffered by an inverter 45 and clocks the latch or register 44. An output of the latch or register 44 is buffered by a string of inverters 46, 47 to provide the internal CPU clock.

Turning now to FIG. 5, there is shown a schematic diagram of a specific circuit corresponding to the block diagram of FIG. 4. The primary phase detector 34 consists of an edge-triggered D flip-flop 51 having an asynchronous reset input (R). The D flip-flop 51 is clocked by the reference clock signal from the inverter 33, and samples the internal CPU clock signal from the inverter 35. The reset input (R) of the D flip-flop 51 receives the ARM_PHASE_DETECT signal, asserted low, from the secondary phase detector 41.

The secondary phase detector 41 consists of an edge-triggered D flip-flop 52. The D flip-flop 52 is clocked by the delayed reference clock from the inverter 40, and samples the internal CPU clock signal from the inverter 42.

The synchronizer 36 consists of a series of edge-triggered D flip-flops, which comprise a shift register 52. The shift register 52 has an asynchronous reset input (R), which is a parallel connection of asynchronous reset inputs of the respective D flip-flops which comprise the shift register.

The state machine logic 43 includes a multiplexer 55 connected to the D flip-flop 53 to form a toggle flip-flop that normally toggles unless an inhibit signal is asserted on a control input 56 of the multiplexer 55. This inhibit signal is responsive to the DELAY_CLOCK from the synchronizer 52. In response to a TEST/DISABLE signal asserted on an inverter 57, however, the state machine is disabled from making any phase corrections. For this purpose, the output of the inverter 57 is combined in an AND gate 58 with the DELAY_CLOCK signal to provide an output asserted on the control input.

In order to ensure that the state machine phase-lock loop does not make more than one phase expansion per correction cycle, the edge-triggered flip-flop 54 holds the toggle signal for one cycle of the state machine clock and uses it to reset the shift register 52. Therefore, the resetting of the shift register 52 disables the shift register from making successive phase expansions, one immediately after another. Moreover, the output of the flip-flop 54 is combined in an OR gate 59 with the ARM_PHASE_DETECT signal so that the secondary phase detector 52 will also prevent multiple phase expansions from occurring due to system jitter after a phase expansion. The shift register 52, for example, has three stages.

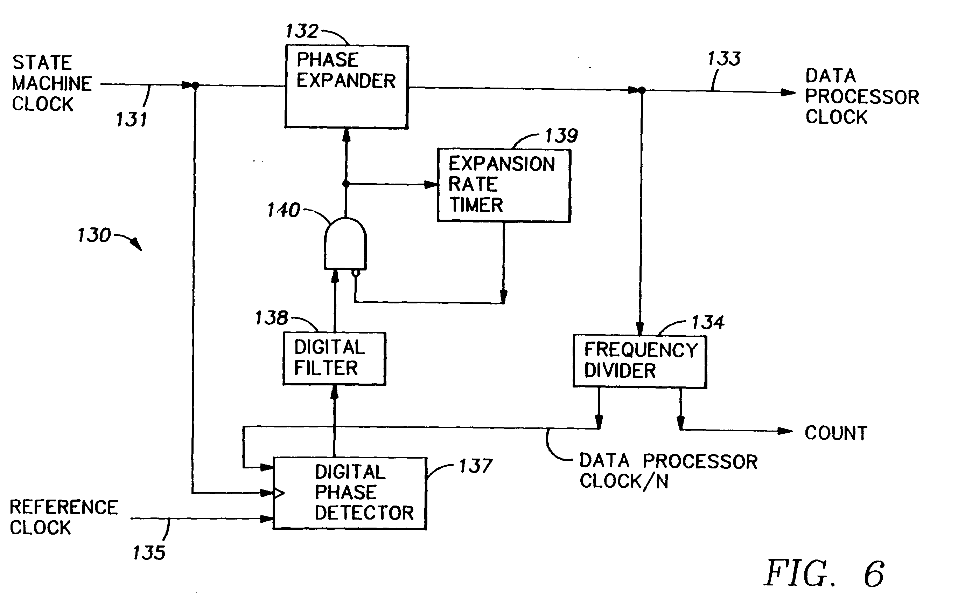

Turning now to FIG. 6, there is shown a block diagram of a second embodiment of a state machine phase lock loop incorporating the present invention. The state machine clock is received on a line 131 and is fed to a phase expander 132 which generates the data processor clock on an output line 133. The data processor clock is fed to a frequency divider 134 which divides the data processor clock by a number N to arrive at the reference clock frequency. The frequency divider 134 also provides a count to the data processor unit so that the data processor unit may synchronize the reception of data, or the performance of other operations, in synchronism with the reference clock, and therefore in synchronism with other synchronized data processing units in the data processing system.

In order to precisely synchronize the phase of the data processing clock 133 with the reference clock, the reference clock and the divided data processor clock from the frequency divider 134 are fed to a digital phase detector 137. The digital phase detector 137 detects when the data processor clock phase has been expanded out of synchronism by a predetermined amount with respect to the reference clock. The output of the digital phase detector 137 is fed to a digital filter 138 which insures that the phase relationship detected by the phase detector 137 occurs for a number of cycles of the reference clock. This insures that phase expansion is not triggered simply by noise on the reference clock line 135, and so that any reference clock jitter is also suppressed to a certain degree. Once it is virtually certain that the phase error condition has resulted from phase error of the reference clock and not noise, the digital filter 138 triggers the phase expander 132 to bring the data processor clock in phase synchronism with the reference clock.

Preferably, the state machine clock 131 is only slightly higher in frequency than the frequency required for synchronizing the data processor clock to the reference clock, so that the phase expander 132 should be triggered at a relatively low rate compared to the frequency of the reference clock 135. Therefore, to further reject noise which might be present on the input line 135 for the reference clock, the state machine phase lock loop 130 includes a means for limiting the rate of phase expansion, such as an expansion rate timer 139 and a gate 140. When the phase expander 132 is enabled, the expansion rate timer 139 is triggered so as to inhibit additional phase expansion until after a certain duration of time. Alternative means could be used for inhibiting the rate of phase expansion, for example, the digital filter 138 could be cleared or reset so as to provide some limiting of the rate of phase expansion even in the absence of the expansion rate timer 139.

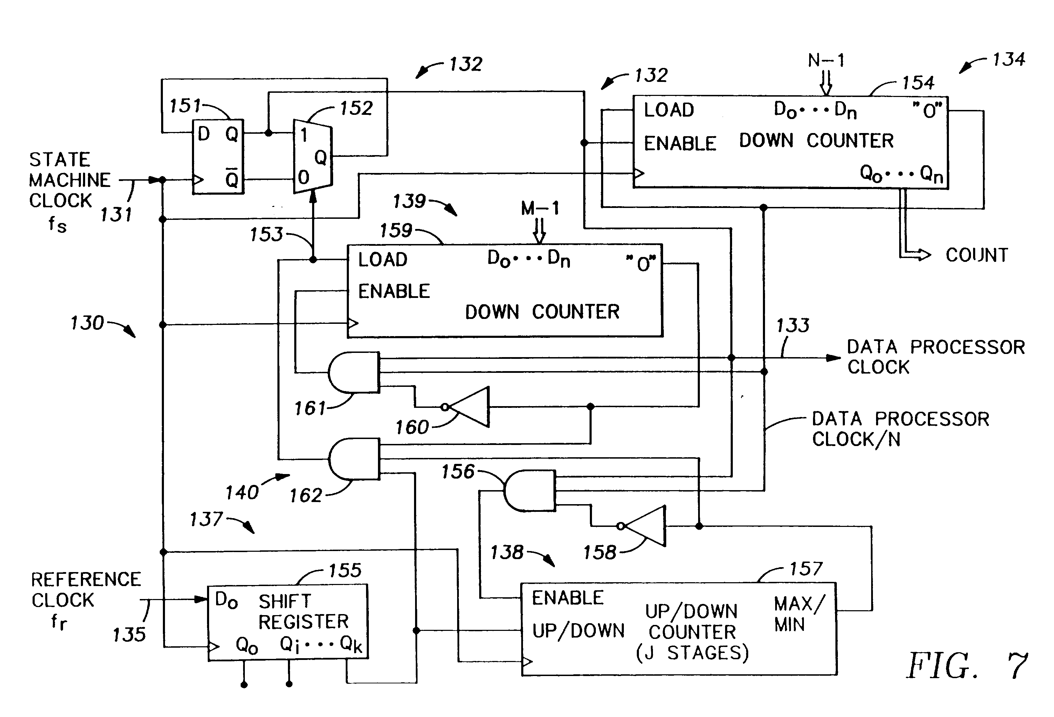

Turning now to FIG. 7, there is shown a detailed schematic diagram of specific circuitry for the state machine phase lock loop 130 of FIG. 6. The phase expander 132 includes a D flip-flop 151 and a multiplexer 152. Usually, the multiplexer 152 receives the complement output of the flip-flop 151 and feeds it back to the D input of the flip-flop. Therefore, the state of the flip-flop toggles during each leading edge of the state machine clock so as to provide a symmetrical data processor clock at one-half of the frequency of the state machine clock. However, when a logic one is asserted on a select input 153 of the multiplexer 152, the true output of the D flip-flop is fed back to its data input so that toggling is inhibited and the phase of the data processor clock is expanded by 180° per cycle of the state machine clock.

The frequency divider 134 is shown as a down counter 154 preset by a constant value N-1 so as to divide the data processor clock by N. It is assumed that the down counter has synchronous data inputs, as well as a synchronous load and synchronous enable input. Therefore, the down counter 134 could have a construction similar to the standard TTL counter part no. 54169.

The phase expander 132 can be viewed as a first stage of a frequency divider or counter including the down counter 154 as a second stage. If the number N is a power of two, then a synchronous binary counter similar to standard TTL part no. 54163A could be substituted for the flip-flop 151, multiplexer 152, and down counter 154.

The digital phase detector 137 includes a shift register 155, which is clocked by the state machine clock 131 and samples the reference clock on line 135. The shift register 155 has a number of stages so that any metastable state caused by sampling a voltage on the reference clock line 135 at the logic threshold has an infinitesimal probability of propagating all of the way through the shift register. Therefore, it can be assumed that the output of the shift register 155 will either be a logic zero or a logic one.

The digital phase detector 137 also includes logic such as an AND gate 156, which, together with a logic one from the shift register 155, causes the digital filter 138 to detect and accumulate occurrences of the phase error condition. The gate 156 receives the data processor clock and the data processor clock divided by N from the counter 154. Therefore, the gate 156 is enabled only during every 2N cycles of the state machine corresponding to the particular phase relationship for triggering of the phase expander 132. Specifically, the digital phase detector 137 detects when the reference clock has a logic high state coincident with clocking by said clocking signal and a predefined state of said frequency divider. If the shift register 155 has six stages (i.e., k=5), and the value N is 3 so that the down counter 154 is loaded with a value of N-1=2, then the digital phase detector 137 will detect the phase relationship illustrated in FIG. 3C.

The digital filter 138 is provided by an up-down counter 157 and an inverter 158 feeding a signal to the gate 156 so as to prevent the up-down counter 157 from "rolling over." In other words, the up-down counter 157 will not count up when it is at its maximum value, and it will not count down when it is at its minimum value. Therefore, the up-down counter functions as a digital integrator for integrating the occurrences of the phase condition. If the up-down counter has J stages, then it will have to accumulate the phase error condition at least $2^J$ times in order to enable phase expansion. The up-down counter has a construction, for example, similar to the standard TTL part no. 54169.

The expansion rate timer 139 is shown in FIG. 5 as including a down counter 159, an inverter 160, and a AND gate 161. The AND gate 61 is enabled by the data processor clock and the data processor clock/N so that it counts at a rate of approximately the reference clock frequency. Moreover, the "zero" output of the down counter is inverted by the inverter 160 and fed to the AND gate 161 so as to disable counting after counting down from a preset value of M minus 1. The phase expander 132 is enabled by a gate 162 when the up-down counter 157 is at its maximum value and receives an UP signal from the shift register 155 so long as the down counter 159 is not counting. Therefore, when the down counter 159 is counting, the phase expander 132 is inhibited. When the down counter 159 has reached its minimum value of zero, the down counter no longer inhibits the gate 162 and the phase expander 132. Once the phase expander 132 is enabled and phase expansion occurs, the down counter becomes loaded with its preset value M minus 1 so as to inhibit any further phase expansion for approximately M cycles of the reference clock.

Clocks for data processors may have accuracies on the order of 75 to 200 ppm. Therefore, the usual instantaneous frequency of data processor clock need only be increased in frequency by a relatively small amount to practice the present invention. The relative "overspeed" of the state machine clock frequency fs, for example, should slightly exceed the sum of the state machine clock accuracy and the reference clock accuracy by a significant margin to ensure that the instantaneous frequency of the data processor clock is always higher than its synchronous frequency so that synchronization may result from selective phase expansion. The relative "overspeed" of the state machine clock fs can be defined as:

$$overspeed = (fs/2N - fr)/fr$$

where fr is the reference clock frequency.

The nominal overspeed of the processor clock should not be much greater than that required to guarantee overspeed, because an excessive overspeed represents a phase contraction. With oscillator accuracies of 75 and 200 ppm, a 12ns external cycle and a 4ns internal cycle, the phase contraction could be less than 1 ps. This does not impact processor performance, although the yield of processor chips is decreased slightly because the chips must run 1 ps faster per processor cycle.

One choice for the value of M is to select M such that the minimum rate of the data processor clock is less than its synchronous frequency by the same amount that its maximum rate exceeds its synchronous frequency. In this case:

*The maximum rate of the data processor clock is $f_s/2$.*

*The minimum rate of the data processor clock is $f_{min}$:*

$$f_{min} = [fs\text{-}f_{min}/NM]2$$

$$2f_{min} = f_s - f_{min}/NM$$

$$f_{min} \left(2 + \frac{1}{NM}\right) = f_s$$

$$f_{min} = \frac{f_s}{2 + \frac{1}{NM}}$$

Let $\Delta f = f_{max}/N - f_r = f_s/2N - f_r$.

For $\Delta f$ also to $= f_r - f_{min}/N$,

then $f_s/2N - f_r = f_r - f_{min}/N$

$$f_s/2N = 2 f_r - \frac{f_s}{2N + \frac{1}{M}}$$

$$\frac{f_s}{2N + \frac{1}{M}} = 2 f_r - \frac{f_s}{2N}$$

$$f_s = 2N \left(2 f_r - \frac{f_s}{2N}\right) + \frac{1}{M} \left(2 f_r - \frac{f_s}{2N}\right)$$

$$\frac{1}{M} \left(2 f_r - \frac{f_s}{2N}\right) = f_s - 2N \left(2 f_r - \frac{f_s}{2N}\right)$$

$$M = \frac{\left(2 f_r - \frac{f_s}{2N}\right)}{f_s - 2N \left(2 f_r - \frac{f_s}{2N}\right)}$$

$$M = \frac{2 f_r - \dfrac{f_s}{2N}}{2 f_s - 4N f_r} = \frac{f_r - \dfrac{f_s}{4N}}{f_s - 2N f_r}$$

$$M \approx \frac{f_r}{2[f_s - 2N f_r]}$$

In view of the above, there has been described a state machine phase lock loop for synchronizing different or independent time domains, such as the internal time domain of a processor to an external system domain. Synchronization is achieved to within one period of the state machine clocking signal, provided that the data processor clock is always gaining phase with respect to the reference clock. The state machine has negligible clock contraction, is low risk, and requires negligible die area for an on-chip implementation.

While the present invention has been described with reference to a few specific embodiments, the description is illustrative of the invention and is not to be construed as limiting the invention. Various modifications may occur to those skilled in the without departing from the true scope of the invention as defined by the appended claims.

## Claims

1. A method of synchronizing a first signal to a second signal, said method comprising the steps of :

   a) providing a first signal and a second signal, the first signal having a first frequency and the second signal having a second frequency, the first frequency being slightly greater than the second frequency or an integer multiple of the second frequency, such that the first signal continually acquires an increasing phase lead over the second signal;
   b) detecting whenever the first signal acquires a predefined phase lead over the second signal;
   c) when said predefined phase lead is detected, expanding the first signal in phase by a predetermined amount to synchronize said first signal to said second signal;
   d) after synchronization, inhibiting further synchronization for a predetermined period to prevent a false detection of predetermined phase lead after phase expansion.

2. The method as claimed in claim 1, further comprising the step of generating said first signal by clocking a frequency divider (44; 132, 134) with a clocking frequency, and wherein said step (c) is performed by inhibiting the clocking of said frequency divider.

3. The method as claimed in claim 2, including the step of synchronizing said second signal to said clocking frequency wherein said step of synchronizing is performed by sampling said second signal in synchronism with said clocking frequency wherein said predetermined phase relationship is detected when said second signal has a predetermined logic state and when said frequency divider has a predefined state coincident with assertion of said clocking signal.

4. A method of synchronizing data processing units in a data processing system using the method of claim 1, comprising the steps of :

   a) generating the second signal by a reference clock and distributing the reference clock to each of the data processing units; and
   b) generating the first signal by a respective data processor clock at each of the data processing units.

5. A digital phase lock loop (16,17) for generating a first frequency signal synchronized to a second frequency signal having a frequency lower than said first frequency signal, said digital phase lock loop comprising:

   a digital state machine (43,44) having a clock input (32) for receiving a clocking signal, an inhibit input (56) for receiving an inhibit signal, and an output (Q), said state machine generating said first frequency signal in response to said clocking signal and expanding the phase of the first frequency signal by a predetermined amount in response to an inhibit signal;
   a digital phase detector (34) having a first input receiving said second frequency signal, a second input (D) receiving said first frequency signal from said output of said state machine, and a phase detector output (Q) connected to said inhibit input (56) of said state machine to supply said inhibit signal whenever said second frequency signal acquires a predefined phase relationship with respect to said first frequency signal; and a secondary phase detector (41,52) having a first input (D) for receiving said first frequency signal from said output of said digital state machine, a second input for receiving said second frequency signal, and a phase detection output (Q) connected to said state machine (43,44) to disable said expanding of phase of said first frequency signal until said second frequency signal has a second predefined phase relationship with respect to said first frequency signal.

6. The digital phase lock loop as claimed in claim 5 further including a synchronizer (36,52) having an input (D) connected to the phase detection output (Q) of said digital phase detector (34,51) and an output $(Q_j)$ connected to said inhibit input (56) of said digital state machine (43,44).

7. The digital phase lock loop as claimed in claim 5 wherein said first phase detector (34) includes a first D flip-flop (51) clocked by said second frequency signal and sampling said first frequency signal, and wherein said secondary phase detector includes a second D flip-flop (52) clocked by a delayed version of said second frequency signal and sampling said first frequency signal, said second D flip-flop having a phase detection output (Q) connected to said state machine (43,44) to disable said expanding of phase of said first frequency signal when said first frequency signal has a predefined phase relationship with respect to said delayed version of said second frequency signal.

8. A digital phase lock loop (16,17) for generating a first frequency signal synchronized to a second frequency signal having a frequency lower than said first frequency signal, said digital phase lock loop comprising:

a counter (132,134) having a clock input (131) for receiving a clocking signal, the counter having a first stage (132) responsive to an inhibit input (153), the first stage for generating said first frequency signal, and the counter also having an additional stage (134) for dividing said first frequency signal down to said second frequency;
a digital phase detector (137) having a first input (135) for receiving said second frequency signal, a second input connected to an output of said counter for receiving said divided first frequency signal, a clock input connected to the clock input (131) of said counter, and a phase detection output $(Q_K)$ connected to said inhibit input (153) of said counter for inhibiting said counter so as to expand the phase of said first frequency signal by a predetermined amount whenever said second frequency signal acquires a predefined phase relationship with respect to said first frequency signal, said predefined phase relationship being determined by said second frequency signal having a predetermined logic state coincident with clocking by said clocking signal and a predefined state of said counter (134); and
an expansion rate timer (139) for inhibiting further phase expansion for a predetermined period after a phase expansion event.

9. The digital phase lock loop as claimed in claim 8, further comprising a digital filter (138) connecting said output of said digital phase detector (137) to said inhibit input (153) of said counter (132,134) so that said counter is inhibited only when said digital phase detector (137) detects that said second frequency signal has said predetermined logic state coincident a plurality of times with said predefined state of said counter and with assertion of said clocking signal.

10. The digital phase lock loop as claimed in claim 8 wherein said digital phase detector (137) comprises a flip-flop (155) clocked by said clocking signal and receiving said second frequency signal for detecting coincidence of said predetermined logic state with said clocking by said clocking signal, and a logic gate (156) having a first input connected to an output $(Q_K)$ of said flip-flop and a second input connected to an output of said counter (132,134) for detecting coincidence with said predefined state of said counter.

**Patentansprüche**

1. Verfahren, um ein erstes Signal mit einem zweiten Signal zu synchronisieren, wobei das Verfahren die Schritte umfaßt:

a) Bereitstellen eines ersten Signales und eines zweiten Signales, wobei das erste Signal eine erste Frequenz

EP 0 572 135 B1

aufweist und das zweite Signal eine zweite Frequenz aufweist, wobei die erste Frequenz leicht größer ist als die zweite Frequenz oder als ein ganzzahliges Vielfaches der zweiten Frequenz, so daß das erste Signal kontinuierlich einen zunehmenden Phasenvorlauf bezüglich des zweiten Signales annimmt;

b) Erfassen des Zeitpunktes, zu welchem das erste Signal einen vorbestimmten Phasenvorlauf bezüglich des zweiten Signales erreicht;

c) Phasenmäßiges Ausdehnen des ersten Signales um ein vorbestimmtes Ausmaß, wenn der vorbestimmte Phasenvorlauf erfaßt wird, um das erste Signal mit dem zweiten Signal zu synchronisieren;

d) Hemmen weiterer Synchronisation für eine vorbestimmte Periode nach der Synchronisierung, um eine fehlerhafte Erfassung des vorbestimmten Phasenvorlaufes nach der Phasenausdehnung zu verhindern.

2. Verfahren nach Anspruch 1, ferner umfassend den Schritt des Erzeugens des ersten Signales mittels Taktung eines Frequenzteilers (44; 132, 134) mit einer Taktfrequenz, wobei der Schritt c) durchgeführt wird mittels Hemmung der Taktung des Frequenzteilers.

3. Verfahren nach Anspruch 2, umfassend den Schritt des Synchronisierens des zweiten Signales bezüglich der Taktfrequenz, wobei der Schritt des Synchronisierens durchgeführt wird mittels Sampeln des zweiten Signales synchron zu der Taktfrequenz, wobei die vorbestimmte Phasenbeziehung erfaßt wird, wenn das zweite Signal einen vorbestimmten Logikzustand annimmt, und wenn der Frequenzteiler einen vorbestimmten Zustand aufweist, übereinstimmend mit der Bestätigung des Taktsignales.

4. Verfahren, um Datenverarbeitungseinheiten in einem Datenverarbeitungssystem unter Verwendung des Verfahrens nach Anspruch 1 zu synchronisieren, umfassend die Schritte:

a) Erzeugen des zweiten Signales durch einen Referenztakt und Verteilen des Referenztaktes auf jede der Datenverarbeitungseinheiten; und

b) Erzeugen des ersten Signales durch einen jeweiligen Datenverarbeitungstakt an jeder der Datenverarbeitungseinheiten.

5. Digitale Phasenfestlegungsschlaufe (16, 17), um ein erstes Frequenzsignal synchron zu einem zweiten Frequenzsignal zu generieren, wobei das zweite Frequenzsignal eine niedrigere Frequenz als das erste Frequenzsignal aufweist, wobei die digitale Phasenfestlegungsschlaufe umfaßt:

eine digitale Zustandsvorrichtung (43, 44) mit einem Takteingang (32), um ein Taktungssignal zu empfangen, einen Hemmungseingang (56), um ein Hemmsignal zu empfangen, und einen Ausgang (Q), wobei die Zustandsvorrichtung das erste Frequenzsignal ansprechend auf das Taktungssignal generiert und die Phase des ersten Frequenzsignales um ein vorbestimmtes Ausmaß ansprechend auf ein Hemmsignal ausdehnt;

eine digitale Phasendetektoreinrichtung (34) mit einem ersten Eingang, der das zweite Frequenzsignal empfängt, einem zweiten Eingang (D), der das erste Frequenzsignal von dem Ausgang der Zustandsvorrichtung empfängt, und einem Phasendetektorausgang (Q), der mit dem Hemmungs- bzw. Hemmeingang (56) der Zustandsvorrichtung verbunden ist, um das Hemmsignal immer dann zuzuführen, wenn das zweite Frequenzsignal eine vorbestimmte Phasenbeziehung mit Bezug auf das erste Frequenzsignal erreicht;

eine Sekundärphasendetektoreinrichtung (41, 52) mit einem ersten Eingang (D), um das erste Frequenzsignal von dem Ausgang der digitalen Zustandsvorrichtung zu empfangen, einem zweiten Eingang, um das zweite Frequenzsignal zu empfangen und mit einem Phasenerfassungsausgang (Q), der mit der Zustandsvorrichtung (43, 44) verbunden ist, um das Ausdehnen bzw. Erweitern der Phase des ersten Frequenzsignales auszuschalten, bis das zweite Frequenzsignal eine zweite vorbestimmte Phasenbeziehung bezüglich des ersten Frequenzsignales aufweist.

6. Digitale Phasenfestlegungsschlaufe nach Anspruch 5, ferner umfassend eine Synchronisationseinrichtung (36, 52) mit einem Eingang (D), der mit dem Phasenerfassungsausgang (Q) der digilalen Phasendetektoreinrichtung (34, 51) verbunden ist, und mit einem Ausgang ($Q_j$), der mit dem Hemmungseingang (56) der digitalen Zustandsvorrichtung (43, 44) verbunden ist.

7. Digitale Phasenfestlegungsschlaufe nach Anspruch 5. bei welcher die erste Phasendetektoreinrichtung (34) einen ersten D-Flipflop (51) umfaßt, der durch das zweite Frequenzsignal getaktet ist und das erste Frequenzsignal sampelt, und bei welcher die Sekundärphasendetektoreinrichtung einen zweiten D-Flipflop (52) umfaßt, der durch eine verzögerte Version des zweiten Frequenzsignales getaktet ist und das erste Frequenzsignal sampelt, wobei der zweite D-Flipflop einen Phasenerfassungsausgang (Q) verbunden mit der Zustandsvorrichtung (43, 44) aufweist, um das Ausdehnen bzw. Erweitern der Phase des ersten Frequenzsignales auszuschalten, wenn das erste Frequenzsignal eine vorbestimmte Phasenbeziehung bezüglich der verzögerten Version des zweiten Frequenzsignales aufweist.

8. Digitale Phasenfestlegungsschlaufe (16, 17), um ein erstes Frequenzsignal synchron zu einem zweiten Frequenzsignal zu generieren, wobei das zweite Frequenzsignal eine niedrigere Frequenz aufweist als das erste Frequenzsignal, wobei die digitale Phasenfestlegungsschlaufe umfaßt:

einen Zähler (132, 134) mit einem Takteingang (131), um ein Taktungssignal zu empfangen, wobei der Zähler eine erste Stufe (132) umfaßt, welche auf einen Hemmungseingang (153) ansprechend ist, wobei die erste Stufe zum Generieren des ersten Frequenzsignales und der Zähler ebenfalls eine zusätzliche Stufe (134) umfassen, um das erste Frequenzsignal hin zu der zweiten Frequenz zu teilen;
eine digitale Phasendetektoreinrichtung (137) mit einem ersten Eingang (135), um das zweite Frequenzsignal zu empfangen, einem zweiten Eingang, der mit einem Ausgang des Zählers verbunden ist, um das geteilte erste Frequenzsignal zu empfangen, einem Takteingang, der mit dem Takteingang (131) des Zählers verbunden ist, und mit einem Phasenerfassungsausgang ($Q_K$), verbunden mit dem Hemmungseingang (153) des Zählers, um den Zähler zu hemmen und somit die Phase des ersten Frequenzsignales um ein vorbestimmtes Ausmaß immer dann auszudehnen, wenn das zweite Frequenzsignal eine vorbestimmte Phasenbeziehung bezüglich des ersten Frequenzsignals erreicht, wobei die vorbestimmte Phasenbeziehung durch das zweite Frequenzsignal bestimmt wird, welches einen vorbestimmten Logikzustand aufweist, der mit der Taktung durch das Taktungssignal und einem vorbestimmten Zustand des Zählers (134) übereinstimmt; und
einen Aufweitungsraten- bzw. -geschwindigkeitszitgeber (139), um eine weitere Phasenausdehnung für eine vorbestimmte Periode nach dem Phasenausdehnungsereignis zu hemmen.

9. Digitale Phasenfestlegungsschlaufe nach Anspruch 8, ferner umfassend einen Digitalfilter (138), der den Ausgang der digitalen Phasendetektoreinrichtung (137) mit dem Hemmungseingang (153) des Zählers (132, 134) in solch einer Weise verbindet, daß der Zähler lediglich gehemmt wird, wenn die digitale Phasendetektoreinrichtung (137) erfaßt, daß das zweite Frequenzsignal den vorbestimmten Logikzustand aufweist, welcher mehrfach übereinstimmt mit dem vorbestimmten Zustand des Zählers und mit der Bestätigung des Taktungssignales.

10. Digitale Phasenfestlegungsschlaufe nach Anspruch 8, bei welcher die digitale Phasendetektoreinrichtung (137) einen Flipflop (155) umfaßt, der durch das Taktungssignal getaktet ist und das zweite Frequenzsignal empfängt, um eine Übereinstimmung des vorbestimmten Logikzustandes mit der Taktung durch das Taktungssignal zu erfassen, sowie ein Logikgatter (156), das einen ersten Eingang, verbunden mit einem Ausgang ($Q_K$) des Flipflopes, und einen zweiten Eingang, verbunden mit einem Ausgang des Zählers (132, 134), aufweist, um Übereinstimmung mit dem vorbestimmten Zustand des Zählers zu erfassen.

## Revendications

1. Procédé de synchronisation d'un premier signal sur un deuxième signal, ledit procédé comprenant les étapes de :

a) fourniture d'un premier signal et d'un deuxième signal, le premier signal ayant une première fréquence et le deuxième signal ayant une deuxième fréquence, la première fréquence étant légèrement supérieure à la deuxième fréquence ou à un entier multiple de la deuxième fréquence, de telle sorte que le premier signal acquiert continuellement une avance de phase accrue sur le deuxième signal;
b) détection de l'instant où le premier signal acquiert une avance de phase prédéfinie sur le deuxième signal;
c) lorsque ladite avance de phase prédéfinie est détectée, extension du premier signal en phase, d'une quantité prédéterminée, pour synchroniser ledit premier signal sur ledit deuxième signal;
d) après la synchronisation, inhibition d'une synchronisation supplémentaire pendant une période prédéterminée, pour empêcher une fausse détection d'une avance de phase prédéterminée après l'extension de phase.

2. Procédé selon la revendication 1, comprenant en outre l'étape de génération dudit premier signal par cadencement d'un diviseur de fréquence (44; 132,134) avec une fréquence de cadencement, et dans lequel ladite étape (c) est effectuée en inhibant le cadencement dudit diviseur de fréquence.

3. Procédé selon la revendication 2, comportant l'étape de synchronisation dudit deuxième signal sur ladite fréquence de cadencement, dans lequel ladite étape de synchronisation est effectuée en échantillonnant ledit deuxième signal en synchronisme avec ladite fréquence de cadencement, ladite relation de phase prédéterminée étant détectée lorsque ledit deuxième signal a un état logique prédéterminé et lorsque ledit diviseur de fréquence a un état prédéfini coïncident avec l'assertion dudit signal de cadencement.

4. Procédé de synchronisation d'unités de traitement de données dans un système de traitement de données utilisant le procédé de la revendication 1, comprenant les étapes de :

   a) génération du deuxième signal par une horloge de référence et distribution de l'horloge de référence à chacune des unités de traitement de données; et
   b) génération du premier signal par une horloge du processeur de données respectif à chacune des unités de traitement de données.

5. Boucle à verrouillage de phase numérique (16,17) pour générer un premier signal de fréquence synchronisé sur un deuxième signal de fréquence ayant une fréquence inférieure à celle dudit premier signal de fréquence, ladite boucle à verrouillage de phase numérique comprenant :

   - une machine d'états numériques (43,44) ayant une entrée d'horloge (32) pour recevoir un signal de cadencement, une entrée d'inhibition (56) pour recevoir un signal d'inhibition, et une sortie (Q), ladite machine d'états générant ledit premier signal de fréquence en réponse audit signal de cadencement et étendant la phase du premier signal de fréquence d'une quantité prédéterminée en réponse à un signal d'inhibition;
   - un détecteur de phase numérique (34) ayant une première entrée recevant ledit deuxième signal de fréquence, une deuxième entrée (D) recevant ledit premier signal de fréquence provenant de ladite sortie de ladite machine d'états, et une sortie (Q) du détecteur de phase, connectée à ladite entrée d'inhibition (56) de ladite machine d'états, pour fournir ledit signal d'inhibition chaque fois que ledit deuxième signal de fréquence acquiert une relation de phase prédéfinie par rapport audit premier signal de fréquence; et
   - un détecteur de phase secondaire (41,52) ayant une première entrée (D) pour recevoir ledit premier signal de fréquence provenant de ladite sortie de ladite machine d'états numériques, une deuxième entrée pour recevoir ledit deuxième signal de fréquence, et une sortie de détection de phase (Q) connectée à ladite machine d'états (43,44) pour invalider ladite extension de phase dudit premier signal de fréquence jusqu'à ce que ledit deuxième signal de fréquence a une deuxième relation de phase prédéfinie par rapport audit premier signal de fréquence.

6. Boucle à verrouillage de phase numérique selon la revendication 5, comportant en outre un synchronisateur (36,52) ayant une entrée (D) connectée à la sortie de détection de phase (Q) dudit détecteur de phase numérique (34,51) et une sortie (Q$_j$) connectée à ladite entrée d'inhibition (56) de ladite machine d'états numériques (43,44).

7. Boucle à verrouillage de phase numérique selon la revendication 5, dans laquelle ledit premier détecteur de phase (34) comporte une première bascule D (51) cadencée par ledit deuxième signal de fréquence et échantillonnant ledit premier signal de fréquence, et dans laquelle ledit détecteur de phase secondaire comporte une deuxième bascule D (52) cadencée par une version retardée dudit deuxième signal de fréquence et échantillonnant ledit premier signal de fréquence, ladite deuxième bascule D ayant une sortie de détection de phase (Q) connectée à ladite machine d'états (43,44) pour invalider ladite extension de phase dudit premier signal de fréquence lorsque ledit premier signal de fréquence a une relation de phase prédéfinie par rapport à ladite version retardée dudit deuxième signal de fréquence.

8. Boucle à verrouillage de phase numérique (16,17) pour générer un premier signal de fréquence synchronisé sur un deuxième signal de fréquence ayant une fréquence inférieure à celle dudit premier signal de fréquence, ladite boucle à verrouillage de phase numérique comprenant :

   - un compteur (132,134) ayant une entrée d'horloge (131) pour recevoir un signal de cadencement, le compteur ayant un premier étage (132) sensible à une entrée d'inhibition (153), le premier étage servant à générer ledit premier signal de fréquence, et le compteur ayant aussi un étage supplémentaire (134) pour diviser ledit premier signal de fréquence à ladite deuxième fréquence;
   - un détecteur de phase numérique (137) ayant une première entrée (135) pour recevoir ledit deuxième signal de fréquence, une deuxième entrée connectée à une sortie dudit compteur pour recevoir ledit premier signal de fréquence divisé, une entrée d'horloge connectée à l'entrée d'horloge (131) dudit compteur, et une sortie de détection de phase (Q$_K$) connectée à ladite entrée d'inhibition (153) dudit compteur pour inhiber ledit compteur afin d'étendre la phase dudit premier signal de fréquence d'une quantité prédéterminée chaque fois que ledit deuxième signal de fréquence acquiert une relation de phase prédéfinie par rapport audit premier signal de fréquence, ladite relation de phase prédéfinie étant déterminée par ledit deuxième signal de fréquence ayant un état logique prédéterminé coïncident avec le cadencement par ledit signal de cadencement et un état prédéfini dudit compteur (134); et

- un temporisateur de rythme d'extension (139) pour inhiber une extension de phase supplémentaire pendant une période prédéterminée après un événement d'extension de phase.

9. Boucle à verrouillage de phase numérique selon la revendication 8, comprenant en outre un filtre numérique (138) connectant ladite sortie dudit détecteur de phase numérique (137) à ladite entrée d'inhibition (153) dudit compteur (132,134) de telle sorte que ledit compteur est inhibé seulement lorsque ledit détecteur de phase numérique (137) détecte que ledit deuxième signal de fréquence a ledit état logique prédéterminé coïncident une pluralité de fois avec ledit état prédéfini dudit compteur et avec l'assertion dudit signal de cadencement.

10. Boucle à verrouillage de phase numérique selon la revendication 8, dans laquelle ledit détecteur de phase numérique (137) comprend une bascule bistable (155) cadencée par ledit signal de cadencement et recevant ledit deuxième signal de fréquence pour détecter la coïncidence dudit état logique prédéterminé avec ledit cadencement par ledit signal de cadencement, et une porte logique (156) ayant une première entrée connectée à une sortie ($Q_K$) de ladite bascule bistable et une deuxième entrée connectée à une sortie dudit compteur (132,134) pour détecter la coïncidence avec ledit état prédéfini dudit compteur.

FIG. 1

**STATE A**

DATA PROCESSOR CLOCK IS
SYNCHRONIZED TO LEADING
EDGE OF REFERENCE CLOCK
(SEE FIG. 3A)

— DATA PROCESSOR CLOCK
GAINING PHASE OVER
REFERENCE CLOCK

**STATE B**

DATA PROCESSOR CLOCK HAS
90° PHASE LEAD OVER LEADING
EDGE OF REFERENCE CLOCK
(SEE FIG. 3B)

— DATA PROCESSOR CLOCK
GAINING PHASE OVER
REFERENCE CLOCK

**STATE C**

DATA PROCESSOR CLOCK HAS
180° PHASE LEAD OVER LEADING
EDGE OF REFERENCE CLOCK
(SEE FIG. 3C)

— STATE MACHINE PHASE
LOCK LOOP DETECTS
180° PHASE RELATIONSHIP

**STATE D**

DATA PROCESSOR CLOCK
PHASE IS EXPANDED BY 180°

(SEE FIG. 3D)

*FIG. 2*

REFERENCE CLOCK
DATA PROCESSOR CLOCK
DATA PROCESSOR CLOCK /3
1 | 0 | 2 | 1 | 0 | 2   COUNT

*FIG. 3A*

REFERENCE CLOCK
DATA PROCESSOR CLOCK
DATA PROCESSOR CLOCK /3
1 | 0 | 2 | 1 | 0 | 2   COUNT

*FIG. 3B*

REFERENCE CLOCK
DATA PROCESSOR CLOCK
DATA PROCESSOR CLOCK /3
1 | 0 | 2 | 1 | 0 | 2 |   COUNT

*FIG. 3C*

21
REFERENCE CLOCK
DATA PROCESSOR CLOCK
DATA PROCESSOR CLOCK /3
1 | 0 | 2 | 1 | 0 | 2   COUNT

*FIG. 3D*

FIG. 4

EP 0 572 135 B1

FIG. 5

FIG. 6

FIG. 7